# EUROPÄISCHE PATENTSCHRIFT

(11) **EP 3 564 203 B1**
(45) Veröffentlichungstag und Bekanntmachung des Hinweises auf die Patenterteilung: **24.04.2024**
(21) Anmeldenummer: 19180746.0
(22) Anmeldetag: 18.07.2014
(51) Int. Cl.: C04B 41/87, C04B 41/89, C03C 17/25

(54) **BESCHICHTETES SUBSTRAT**
COATED SUBSTRATE
SUBSTRAT REVÊTU

(43) Veröffentlichungstag der Anmeldung: 06.11.2019
(62) Teilanmeldung aus: 14177717.7
(73) Patentinhaber: ERLUS AKTIENGESELLSCHAFT, 84088 Neufahrn (DE)
(72) Erfinder: Prof. Dr. BAHNEMANN, Detlef, 30826 Garbsen (DE); Dr. FLEISCH, Manuel, 30855 Langenhagen (DE); Dr. GAST, Eduard, 84559 Kraiburg (DE); HACKER, Alois, 84061 Ergoldsbach (DE); Dr. ACKERHANS, Carsten, 84066 Mallersdorf-Pfaffenberg (DE); Dr. STOLL, Alexander, 85354 Freising (DE)
(74) Vertreter: Louis Pöhlau Lohrentz

(56) Entgegenhaltungen:
- DE-A1- 3 742 373
- US-A- 2 692 836
- SUMANTA K. TRIPATHY ET AL: "Thermally evaporated mechanically hard tin oxide thin films for opto-electronic apllications", AIP CONFERENCE PROCEEDINGS, 1. Januar 2014 (2014-01-01), Seiten 176-179, XP055616350, NEW YORK, US ISSN: 0094-243X, DOI: 10.1063/1.4862013

## Beschreibung

Die vorliegende Erfindung betrifft ein beschichtetes Substrat mit wenigstens einer elektrisch leitfähigen Beschichtung umfassend Wolfram-dotiertes Zinnoxid.

Die Entwicklung transparenter leitfähiger Beschichtungen ist ein Feld intensiver Forschungsbemühungen. Ursache dieses großen Interesses ist vor allem das rasante Wachstum der Nachfrage nach Photovoltaikmodulen, beispielsweise Solarzellen, oder nach optoelektronischen Modulen oder Geräten wie beispielsweise Smartphones oder Tablet-Computern.

Die verwendeten Materialien müssen dabei eine gute elektrische Leitfähigkeit und vorzugsweise eine hohe optische Transparenz aufweisen. Vorteilhaft sind außerdem ein niedriger Preis, ein einfaches Auftragungsverfahren sowie eine geringe Toxizität.

Gängige Materialien mit breiter kommerzieller Anwendung sind Indium-dotiertes Zinn(IV)-Oxid (ITO) und Fluor-dotiertes Zinn(IV)-Oxid (FTO).

Die verwendeten Materialien werden in der Regel im Vakuum durch Sputtern aufgetragen. Dies führt zu exzellenten Leitfähigkeiten und hohen optischen Transparenzen.

Sputtern ist jedoch ein vergleichsweise aufwendiges Verfahren. Darüber hinaus können beispielsweise bei der Herstellung einer Fluor-dotierten Zinn(IV)-Oxid Beschichtung durch das eingesetzte Fluor toxische Nebenprodukte entstehen.

Die Verwendung von Indium-dotiertem Zinn(IV)-Oxid ist dagegen sehr kostenintensiv. Weitere aus dem Stand der Technik bekannte transparente, leitfähige Beschichtungen sind beispielsweise Antimon-dotiertes Zinn(IV)-Oxid (ATO) oder Wolfram-dotiertes Zinn(IV)-Oxid (TTO).

Die Nichtpatentliteratur Huang et al. (J. Sol-Gel Sci. Technol. 2010 (54), Seiten 276 bis 281) beschreibt transparente leitfähige Wolfram-dotierte Zinnoxidfilme, die durch Sol-Gel-Technik auf Quarzglassubstraten abgeschieden wurden.

Wie aus der Nichtpatentliteratur Huang et al. (2010), Seite 280 hervorgeht, hat die Konzentration der Wolfram-Dotierung einen unterdrückenden Effekt auf das Wachstum von polykristallinen Filmen.

Die Nichtpatentliteratur Huang (2009) (Thin solid films, 2009 (518), Seiten 1892-1896) beschreibt amorphe Wolfram-dotierte Zinnoxidfilme und deren Herstellung.

Die chinesische Patentanmeldung CN 101413099 A beschreibt die Herstellung von polykristallinen Wolfram-dotierten Zinn(IV)-Oxidfilmen unter Verwendung von Puls-Plasma-Abscheidung (PPD: pulse plasma deposition), wobei Zinndioxid und metallisches Wolfram zerkleinert, gemischt, vorgeformt und durch Sintern in ein Blockförmiges Material überführt werden, das mittels Puls-Plasma-Abscheidung auf Quarzglassubstrate übertragen wird.

Das beschriebene Verfahren ist aufwendig. Beispielsweise wird das verwendete elementare Wolfram in Gegenwart von Zinn(IV)-oxid 12 h bei 800°C oxidiert und das erhaltene Mischoxid anschließend gemahlen, um eine homogene Durchmischung des Mischoxids zu erreichen. Das durchmischte Mischoxid-Pulver wird nachfolgend für 12 h bei 850°C gesintert, um ein PPD-Target zu erhalten, das mittels eines Plasmastrahls verdampft werden kann.

S.K. Tripathy et al., AIP Conference Proceedings 1576, 176 (2014) offenbart thermisch verdampfte mechanisch harte Zinnoxid-Dünnschichtfilme für opto-elektronische Anwendungen.

Aufgabe der vorliegenden Erfindung ist es somit, ein beschichtetes Substrat mit wenigstens einer elektrisch leitfähigen Beschichtung bereitzustellen, wobei die Beschichtung eine gute elektrische Leitfähigkeit aufweist.

Darüber hinaus soll die hergestellte elektrisch leitfähige Beschichtung hoch temperaturbeständig und chemisch stabil gegen Korrosion sein.

Die Aufgabe der vorliegenden Erfindung wird gelöst durch die Bereitstellung eines beschichteten Substrats umfassend wenigstens eine elektrisch leitfähige Beschichtung umfassend kristallines Wolfram-dotiertes Zinnoxid gemäß Anspruch 1..

Bevorzugte Ausführungsformen des erfindungsgemäßen beschichteten Substrats sind in den abhängigen Ansprüchen 2 bis 10 angegeben.

Das erfindungsgemäß beschichtete Substrat mit wenigstens einer elektrisch leitfähigen Beschichtung, umfassend kristallines Wolfram-dotiertes Zinnoxid, vorzugsweise kristallines Wolfram-dotiertes Zinn(IV)-oxid,weist eine elektrische leitfähige Beschichtung mit einer Schichtdicke aus einem Bereich von 170 bis 5000 nm auf.

Ein Verfahren zum Herstellen einer elektrisch leitfähigen Beschichtung, die kristallines Wolfram-dotiertes Zinnoxid, vorzugsweise kristallines Wolfram-dotiertes Zinn(IV)-Oxid, umfasst oder daraus besteht, umfasst folgenden Schritt:
a) Sprühpyrolysieren einer Lösung, die in einem Lösungsmittel wenigstens eine lösliche Zinnverbindung und wenigstens eine lösliche Wolframverbindung enthält in Gegenwart von Sauerstoff oder Sauerstoff-abgebender/en Verbindung(en) unter Erzeugung einer kristallines Wolfram-dotiertes Zinnoxid-haltigen Schicht, vorzugsweise einer kristallines Wolfram-dotierten Zinn(IV)-Oxid-haltiges Schicht.

Die Erfinder haben überraschend festgestellt, dass sich mit dem vorgenannten Verfahren eine Wolfram-dotierte Zinnoxid-haltigen Schicht, vorzugsweise Wolfram-dotiertes Zinn(IV)-Oxid-haltige Schicht, abscheiden lässt, die im Wesentlichen kristallin, vorzugsweise kristallin, ist.

Eine elektrisch leitfähige Beschichtung, die vorzugsweise durch das vorgenannte Verfahren hergestellt wurde, umfasst kristallines, Wolfram-dotiertes Zinnoxid, vorzugsweise Wolfram-dotiertes Zinn(IV)-Oxid. Vorzugsweise besteht die elektrisch leitfähige Beschichtung aus kristallinem Wolfram-dotierten Zinnoxid, vorzugsweise aus kristallinem Wolfram-dotierten Zinn(IV)-Oxid.

Die elektrische leitfähige Beschichtung weist eine Schichtdicke aus einem Bereich von 170 bis 5000 nm, vorzugsweise aus einem Bereich von 450 bis 3400 nm, vorzugsweise aus einem Bereich von 780 bis 2700 nm, weiter vorzugsweise aus einem Bereich von 1000 bis 2000 nm, auf.

Bei einer bevorzugten Ausführungsform des vorgenannten Verfahrens wird als Lösungsmittel ein organisches Lösungsmittel verwendet, wobei das organische Lösungsmittel vorzugsweise weniger als 15 Vol.-% Wasser, weiter vorzugsweise weniger als 9 Vol.-%, noch weiter vorzugsweise weniger als 5 Vol.-% Wasser, jeweils bezogen auf das Gesamtvolumen des Lösungsmittels, enthält.

Vorzugsweise sind geeignete organische Lösungsmittel aliphatische Alkohole, aliphatische Ether, aliphatische Ketone, aliphatische Aldehyde und Mischungen derselben.

Gemäß einer bevorzugten Variante werden als organische Lösungsmittel aliphatische Alkohole verwendet. Vorzugsweise handelt es sich bei den aliphatischen Alkoholen um Methanol, Ethanol oder Mischungen davon. Äußerst bevorzugt wird als organisches Lösungsmittel Ethanol verwendet.

Bei einer weiteren bevorzugten Variante des vorgenannten Verfahrens werden als Zinnverbindung, vorzugsweise Zinn(IV)-Verbindung, Zinnsalze, vorzugsweise Zinn(IV)-Salze, verwendet. Geeignete Zinnsalze, vorzugsweise Zinn(IV)-Salze, sind vorzugsweise in organischem Lösungsmittel lösliche Zinnsalze. Vorzugsweise sind die Zinnsalze, weiter bevorzugt Zinn(IV)-Salze, in aliphatischem Alkohol, vorzugsweise Methanol, Ethanol oder Mischungen davon löslich. Äußerst bevorzugt sind die Zinnsalze, weiter bevorzugt Zinn(IV)-Salze, in Ethanol löslich.

Bei dem vorzugsweise verwendeten Ethanol handelt es sich um technisches Ethanol mit einem Ethanolgehalt von etwa 96 bis 99 Vol.-%. Das Ethanol kann mithin Vergällungsmittel, beispielsweise Methylethylketon, und/oder Wasser in einer Menge von etwa 1 bis 4 Vol.-% enthalten. Selbstverständlich kann auch reines und getrocknetes Ethanol verwendet werden.

Geeignete Zinnsalze, vorzugsweise Zinn(IV)-Salze, umfassen beispielsweise Zinnhalogenide, vorzugsweise Zinn(IV)-halogenide, die aus der Gruppe, die aus Zinn(IV)-chlorid, Zinn(IV)-bromid, Zinn(IV)-jodid, Hydraten davon, Komplexen davon und Mischungen derselben besteht, ausgewählt werden. Weitere geeignete Zinnsalze, vorzugsweise Zinn(IV)-Salze, umfassen beispielsweise Zinn(IV)-sulfat, Zinn(IV)-nitrat, Hydrate davon, Komplexe davon oder Mischungen derselben.

Ein geeignetes Hydrat ist beispielsweise Zinn(IV)-chlorid-pentahydrat.

Geeignete Komplexe sind beispielsweise Hexachlorozinnsäure H₂[SnCl₆] oder Hexachlorozinnsäurehexahydrat H₂SnCl₆ x 6 H₂O oder Ammoniumhexachlorostannat (NH₄)₂[SnCl₆]).

Des Weiteren sind metallorganische Zinnverbindungen, vorzugsweise metallorganische Zinn(IV)verbindungen, sehr geeignet. Für die Zwecke der vorliegenden Erfindung geeignete metallorganische Zinnverbindungen sind beispielsweise Zinn(IV)-acetat, Zinn(IV)-bis(acetylacetonat)dichlorid, Zinn(IV)-bis(acetylacetonat)dibromid, Zinn(IV)-tert-butoxid, Tetrakis(dimethylamido)zinn(IV), Zinn(IV)isopropoxid, Mono-, Di-, Tri-, Tetrabutylzinn. Des Weiteren sind allgemein R₄Sn, R₃SnX, R₂SnX₂, RSnX₃, wobei vorzugsweise R unabhängig voneinander für einen Kohlenwasserstoffrest mit 1 bis 10, vorzugsweise 2 bis 6, Kohlenstoffatomen ist, für die Zwecke der Erfindung verwendbar. Vorzugsweise werden die Kohlenwasserstoffreste unabhängig voneinander aus der Gruppe ausgewählt, die aus Formyl-, Alkyl-, Aryl-, Allyl-, Vinyl-, Acetyl- und Acylrest besteht. X ist vorzugsweise Halogenid und/oder Hydroxyl. Wenn X Halogenid ist, wird X vorzugsweise aus der Gruppe, die aus Chlorid, Bromid, Iodid und Mischungen davon besteht, ausgewählt.

Anstelle von metallorganischen Zinn(IV)Verbindungen können auch Zinn(II)verbindungen, beispielsweise Zinn(II)ethylhexanoat, verwendet werden.

Weiterhin werden bevorzugt als Wolframverbindungen, vorzugsweise Wolfram(VI)-Verbindungen, Wolframsalze, vorzugsweise Wolfram(VI)-Salze, verwendet.

Geeignete Wolframsalze, vorzugsweise Wolfram(VI)-Salze, sind beispielsweise Wolframhalogenide, vorzugsweise Wolfram(VI)-halogenide, die aus der Gruppe, die aus Wolfram(VI)chlorid, Wolfram(VI)bromid, Wolfram(VI)jodid und Mischungen davon besteht, ausgewählt werden. Weitere geeignete Wolframsalze, vorzugsweise Wolfram(VI)-Salze, umfassen beispielsweise Wolfram(VI)sulfat, Wolfram(VI)nitrat, Wolfram(VI)hexacarbonyl, Wolfram(VI)oxychlorid, Wolfram(VI)dichloridoxid, Bis(tert-butylimino)bis(dimethylamino)wolfram(VI) und/oder Wolfram(VI)ethoxid. Die vorgenannten Wolframsalze umfassen auch Komplexe und Hydrate.

Auch metallorganische Wolframverbindungen sind für die Zwecke der vorliegenden Erfindung sehr geeignet. Beispielsweise können Wolframoxo-alkoxide, vorzugsweise mit der chemischen Formel WO(OR)₄, wobei R unabhängig voneinander für einen Kohlenwasserstoffrest mit 1 bis 10 Kohlenstoffatomen, vorzugsweise 2 bis 6 Kohlenstoffatomen, steht, verwendet werden. Bei dem Kohlenwasserstoffrest kann es sich beispielsweise um tert-Butyl-, iso-Propyl-, Alkyl-, OCH₂-tert-Butyl- oder Mischungen davon handeln. Weitere geeignete metallorganische Verbindungen sind beispielsweise Wolframoxo-alkoxid/β-Diketonverbindung(en), vorzugsweise mit der chemischen Formel WO(OR)s L, wobei R unabhängig voneinander für einen Kohlenwasserstoffrest mit 1 bis 10 Kohlenstoffatomen, vorzugsweise 2 bis 6 Kohlenstoffatomen, vorzugsweise für tert-Butyl- und/oder iso-Propyl- steht und wobei L vorzugsweise für eine β-Diketonverbindung, beispielsweise für Acetylacetonat, steht. Geeignete Sauerstoff- oder gasförmige Sauerstoff-abgebende Verbindung(en) werden vorzugsweise aus der Gruppe, die aus Sauerstoff, Luft und Mischungen davon besteht, ausgewählt. Vorzugsweise wird Sauerstoff oder Luft verwendet. Im Hinblick auf die allgemeine Verfügbarkeit wird vorzugsweise Luft verwendet.

Bei einer bevorzugten Variante des vorgenannten Verfahrens wird das Sprühpyrolysieren in Gegenwart wenigstens eines, vorzugsweise inerten, Trägergases, das aus der Gruppe, die aus Helium, Neon, Argon, Stickstoff und Mischungen davon besteht, ausgewählt wird, durchgeführt. Bei dieser Vorgehensweise erfolgt das Sprühpyrolysieren in einer sauerstoffhaltigen Atmosphäre, vorzugsweise Luft. Mithin kommt die zu versprühende Lösung mit den Zinn- und Wolframverbindungen bei dieser Verfahrensvariante erst im Moment des Sprühvorganges mit einer oder mehreren Sauerstoff abgebenden Komponenten, vorzugsweise Luft, in Kontakt.

Der Anteil an Sauerstoff oder gasförmiger/en Sauerstoff-abgebender/en Verbindung(en) liegt vorzugsweise in einem Bereich von 5 bis 30 Vol.-%, weiter bevorzugt von 18 bis 22 Vol.-%, jeweils bezogen auf das Gesamtvolumen von Trägergas und Sauerstoff oder gasförmiger Sauerstoff-abgebender Verbindung bzw. Sauerstoff-abgebenden Verbindungen. Der Anteil von Sauerstoff in der Luft liegt bei etwa 21 Vol.-%.

Das Sprühpyrolysieren erfolgt vorzugsweise in Intervallen. Die Intervalle liegen dabei im Bereich von 0,1 bis 10 Sekunden, vorzugsweise von 0,5 bis 5 Sekunden, weiter bevorzugt von 0,8 bis 2 Sekunden. Als sehr geeignet hat sich ein Intervall von 1 Sekunde erwiesen.

Bei einer Sprühpyrolyse in Intervallen erfolgt der Sprühvorgang für den angegebenen Zeitraum. Der Zeitraum der Unterbrechung, d.h. der Zeitraum, in dem kein Sprühvorgang erfolgt, entspricht gemäß einer bevorzugten Variante, dem Zeitraum des Sprühvorganges.

Durch den Sprühvorgang, d.h. das Versprühen der zu verwendenden Lösung, kann es zu einer Abkühlung des, vorzugsweise erwärmten, Substrates kommen. In dem Zeitraum der Unterbrechung der Sprühpyrolyse kann das Substrat wieder erwärmt werden. Bei dem Substrat handelt es sich um ein keramisches Substrat, vorzugsweise eine Grobkeramik, beispielsweise einen Dachziegel, Ziegel oder eine Fassadenwand, oder ein polymeres organisches Substrat. Vorzugsweise ist das Substrat ein Dachziegel.

Der Zeitraum der Unterbrechung kann auch kürzer oder länger als der Zeitraum des Sprühvorganges gewählt werden. Die Dauer der gewählten Unterbrechung hängt davon ab, wie stark das Substrat durch das Aufsprühen der Lösung abggekühlt wird, bzw. wie lange die Aufheizung des Substrates auf die gewünschte Temperatur dauert.

Als geeignet erwiesen hat sich ein Sprühpyrolysieren, das in einem Intervall von 1 s, gefolgt von einer Unterbrechung von 1 s, erfolgt. Diese Intervalle werden wiederholt, bis die gewünschte Schichtdicke aufgebracht ist, beispielsweise 10 bis 500 mal oder 15 bis 200 mal oder 20 bis 100 mal oder 25 bis 50 mal.

Die Substrattemperatur beträgt vorzugsweise wenigstens 400°C, weiter bevorzugt wenigstens 450°C. Vorzugsweise liegt die Substrattemperatur in einem Bereich von 400°C bis 1300°C, weiter bevorzugt von 450°C bis 1000°C, noch weiter bevorzugt von 500 bis 750°C, noch weiter bevorzugt von 550°C bis 700°C.

Die Aufheizung des Substrates kann mit den üblichen technischen Mitteln erfolgen, beispielsweise durch Widerstandsheizung und/oder durch Einstrahlung von IR-Strahlung.

Bei einer weiteren bevorzugten Variante der Erfindung weisen das Substrat und die aufgebrachte erfindungsgemäße elektrisch leitfähige Beschichtung einen sehr ähnlichen, vorzugsweise nahezu identischen, Wärmeausdehnungskoeffizienten auf. Gemäß einer bevorzugten Weiterbildung der Erfindung liegt die prozentuale Abweichung bei dem Wärmeausdehnungskoeffizienten der erfindungsgemäß zu verwendenden Beschichtung, bezogen auf den Wärmeausdehnungskoeffizienten des Substrates, bei weniger als 10%, vorzugsweise bei weniger als 7%, noch weiter vorzugsweise bei weniger als 5%, noch weiter vorzugsweise bei 0%. Insbesondere bei einem Keramiksubstrat, beispielsweise einem Dachziegel, ist es wesentlich, dass bei Sonneneinstrahlung keine Beschädigungen aufgrund thermischer Spannungen auftreten. Beispielsweise können sich Dachziegel im Hochsommer auf einem Dach auf Temperaturen von bis zu 60 °C oder 70°C aufwärmen bzw. im Winter beispielsweise auf -25°C bis -35°C abkühlen.

Bei einer bevorzugten Variante des vorgenannten Verfahrens wird während der Sprühpyrolyse Ultraschall eingestrahlt.

Bei dem vorgenannten Verfahren wird die auf das Substrat aufzubringende Lösung, die wenigstens eine lösliche Zinnverbindung und wenigstens eine lösliche Wolframverbindung enthält, vorzugsweise in Tropfenform auf das zu beschichtende Substrat aufgebracht. Das Überführen der Lösung in Tropfenform kann durch Versprühen mit Druckgas, beispielsweise Druckluft, erfolgen.

Bei Einstrahlung von Ultraschall während der Sprühpyrolyse kann der Anteil an Druckgas, beispielsweise Druckluft, mit dem die Lösung, die wenigstens eine lösliche Zinnverbindung und wenigstens eine lösliche Wolframverbindung enthält, versprüht wird, verringert werden.

Gemäß einer bevorzugten Variante des vorgenannten Verfahrens wird auf Druckgas, beispielsweise Druckluft, vollständig verzichtet. Bei dieser Verfahrensvariante wird die aufzubringende Lösung durch Einstrahlung von Ultraschall in die Tropfenform überführt. Bei dieser Verfahrensvariante kann die Tropfenbildung mithin durch Kaltvernebelung erfolgen.

Durch eine Verringerung von Druckgas, vorzugsweise Druckluft, während des Beschichtungsvorganges erfolgt die Abkühlung der Oberfläche des zu beschichtenden Substrats weniger stark. Das Druckgas, vorzugsweise die Druckluft, bewirkt neben den auf die erwärmte Substratoberfläche auftretenden Flüssigkeitstropfen eine nicht unwesentliche Abkühlung der Substratoberfläche. Insoweit erfolgt bei einer bevorzugten Verfahrensvariante die Aufbringung der Lösung, die wenigstens eine lösliche Zinnverbindung und wenigstens eine lösliche Wolframverbindung enthält, ausschließlich mittels Ultraschall. Bei dieser Verfahrensvariante wird die zu beschichtende Substratoberfläche am geringsten durch den Sprüh- bzw. Beschichtungsvorgang abgekühlt. Somit können vorzugsweise bei dem oben genannten Aufsprühen bzw. Beschichten in Intervallen die Heizintervalle zur erneuten Aufheizung der Substratoberfläche zeitlich verkürzt werden. Bei einer bevorzugten Verfahrensvariante kann bei Einstrahlung von Ultraschall die Sprühpyrolyse, mithin das Beschichtungsverfahren, kontinuierlich geführt werden. Somit ist bei einer bevorzugten Verfahrensvariante ein Durchführen der Sprühpyrolyse in Intervallen nicht erforderlich, so dass der Durchsatz bzw. die Produktivität des Verfahrens signifikant erhöht ist.

Ein weiterer wesentlicher Vorteil bei der zusätzlichen oder ausschließlichen Verwendung von Ultraschall ist, dass die Tropfengröße der aufzubringenden Lösung definiert eingestellt werden kann. Über die Tropfengröße kann die elektrisch leitfähige Beschichtung kontrolliert aufgebracht werden. Beispielsweise kann die Schichtdicke der elektrisch leitfähigen Beschichtung kontrolliert eingestellt werden.

Die Tropfengröße bzw. der Tropfendurchmesser liegt bei Einstrahlung von Ultraschall vorzugsweise in einem Bereich von 26 bis 19 µm, weiter bevorzugt von 24 bis 21 µm, noch weiter bevorzugt von 23 bis 22 µm.

Der eingestrahlte Ultraschall liegt vorzugsweise in einem Bereich von 40 bis 60 kHz, weiter bevorzugt von 45 bis 55 kHz, noch weiter bevorzugt von 50 bis 51 kHz. Vorzugsweise wird das Sprühpyrolysieren bei einem Druck aus einem Bereich von 0,1 bar bis 1 bar, weiter bevorzugt von 0,20 bar bis 0,80 bar, durchgeführt. Als sehr geeignet hat sich ein Bereich von 0,30 bar bis 0,70bar erwiesen. Vorzugsweise erfolgt das Sprühpyrolysieren bei einem Druck von etwa 0,5 bar. Bei diesem Druck handelt es sich um den Sprühdruck, mit dem die zu verwendende Lösung versprüht wird. Vorzugsweise wird das Sprühpyrolysieren für einen Zeitraum von 1 s bis 1 h, weiter bevorzugt von 10 s bis 30 Minuten, weiter bevorzugt von 15 s bis 15 Minuten, noch weiter bevorzugt von 20 s bis 5 Minuten, noch weiter bevorzugt von 20 s bis 1 Minute, durchgeführt.

Die Erfinder haben festgestellt, dass sich die Schichtdicke der mit dem vorgenannten Verfahren hergestellten elektrisch leitfähigen Beschichtung in einfacher Weise durch Variation des Drucks und/oder der eingestrahlten Frequenz des Ultraschalls und/oder der Beschichtungsdauer einstellen lässt.

Das vorgenannte Verfahren kann in apparativer Hinsicht in sehr einfacher Form durchgeführt werden. So kann die Lösung, die in einem Lösungsmittel wenigstens eine lösliche Zinnverbindung und wenigstens eine lösliche Wolframverbindung enthält, über einen herkömmlichen Ultraschallzerstäuber auf das vorzugsweise erhitzte Substrat aufgebracht werden. Die zu versprühende Lösung wird vorzugsweise einem Vorratsbehälter vorzugsweise unter Verwendung einer Pumpe entnommen und dem Ultraschallzerstäuber zugeführt.

Das Substrat kann dabei beispielsweise auf einer Heizplatte angeordnet und von der der zu beschichtenden Oberfläche des Substrates abgewandten Oberfläche beheizt sein. Der Ultraschallzerstäuber kann über der zu beschichtenden Oberfläche in einer Sauerstoffatmosphäre, vorzugsweise Luft, in der X- und Y-Ebene verfahrbar angeordnet sein. Der Abstand (Z-Achse) zwischen Ultraschallzerstäuber ist variabel einstellbar. Durch, optional mehrfaches, "Abfahren" der zu beschichtenden Oberfläche mit dem Ultraschallzerstäuber kann die zu versprühende Lösung aufgebracht werden, bis eine gewünschte Schichtdicke oder gewünschte elektrische Leitfähigkeit eingestellt ist. Bei dieser apparativen Ausgestaltung wird der Sauerstoff über die Umgebungsluft zugeführt. Alternativ kann selbstverständlich die auf die Substratoberfläche aufzubringende Lösung unter Verwendung von Druckgas, beispielsweise Druckluft, über eine herkömmliche Sprühdüse aufgebracht werden.

Mit dem vorgenannten Verfahren kann eine elektrisch leitfähige Beschichtung in einer Schichtdicke aus einem Bereich von 170 nm bis 5000 nm, vorzugsweise 450 bis 3400 nm, vorzugsweise 780 bis 2700 nm, vorzugsweise 1000 bis 2000 nm, hergestellt werden.

Die Erfinder haben weiterhin festgestellt, dass die, vorzugsweise mit dem vorgenannten Verfahren hergestellte, elektrisch leitfähige Beschichtung umfassend kristallines Wolfram-dotiertes Zinnoxid, vorzugsweise Wolfram-dotiertes Zinn(IV)-Oxid, eine hohe mechanische Stabilität aufweist. Durch die hohe mechanische Stabilität wird beispielsweise ein Ablösen der elektrisch leitfähigen Beschichtung bei einer weiteren Verarbeitung oder Bearbeitung, beispielsweise einer nachfolgenden Beschichtung, verhindert. Weiterhin zeigt die elektrisch leitfähige Beschichtung einen geringen Abrieb bei mechanischer Beanspruchung.

Bei einer weiteren bevorzugten Variante des vorgenannten Verfahrens enthält die Lösung, die in einem Lösungsmittel wenigstens eine lösliche Zinnverbindung, vorzugsweise Zinn(IV)-Verbindung, und wenigstens eine lösliche Wolframverbindung vorzugsweise Wolfram(VI)-Verbindung, Wolfram in einem Anteil von 0,1 bis 20 Molprozent, vorzugsweise 1 bis 5 Molprozent, weiter vorzugsweise 2 bis 4 Molprozent, jeweils bezogen auf die Gesamtstoffmenge an Wolfram und Zinn.

Durch Verwendung einer Lösung, die in einem Lösungsmittel wenigstens eine lösliche Zinnverbindung, vorzugsweise Zinn(IV)-Verbindung, und wenigstens eine lösliche Wolframverbindung, vorzugsweise Wolfram(VI)-Verbindung, Wolfram in einem Anteil von 0,1 bis 20 Molprozent, vorzugsweise 1 bis 5 Molprozent, jeweils bezogen auf die Gesamtstoffmenge an Wolfram und Zinn, enthält, kann mit dem vorgenannten Verfahren in einfacher und kostengünstiger Weise die elektrisch leitfähige Beschichtung hergestellt werden, die kristallines Wolfram-dotiertes Zinnoxid, vorzugsweise Wolfram-dotiertes Zinn(IV)-Oxid, umfasst oder daraus besteht, wobei vorzugsweise das kristalline Wolfram-dotierte Zinnoxid Wolfram in einem Anteil von 0,1 bis 20 Molprozent, vorzugsweise 1 bis 5 Molprozent, weiter vorzugsweise 2 bis 4 Molprozent, jeweils bezogen auf die Gesamtstoffmenge an Wolfram und Zinn des Wolfram-dotierten Zinnoxids, enthält.

Die Wolfram-dotierte Zinnoxidschicht ist eine Schicht, die kristallines, Wolfram-dotiertes Zinnoxid, vorzugsweise Wolfram-dotiertes Zinn(IV)-Oxid, enthält oder daraus besteht.

Weiter bevorzugt ist die Schicht mit oder aus Wolfram-dotiertem Zinnoxid, vorzugsweise Wolfram-dotiertem Zinn(IV)-Oxid, eine polykristalline Schicht, die aus vielen kleinen Einzelkristallen, die auch als Kristallite bezeichnet werden können, aufgebaut. Benachbarte Kristallite der polykristallinen Schicht können sich in der Orientierung ihres Kristallgitters unterscheiden.

Die Wolfram-dotiertes Zinnoxid-haltige Schicht, vorzugsweise Wolfram-dotiertes Zinn(IV)-Oxid-haltige Schicht, weist kolumnare Kristallite auf, die eine säulenartige Struktur aufweisen, die weiter bevorzugt in gleicher Richtung, d.h. im Wesentlichen parallel zueinander, ausgerichtet ist. Vorzugsweise werden die Kristallite durch ein kolumnares Schichtwachstum während der Herstellung gebildet. Gemäß einer bevorzugten Variante der Erfindung umfasst die elektrisch leitfähige Schicht kolumnares Wolfram-dotiertes Zinnoxid, vorzugsweise Wolfram-dotiertes Zinn(IV)-Oxid, oder besteht daraus.

Die Erfinder haben festgestellt, dass durch Aufbau der kristallinen, vorzugsweise polykristallinen, Wolfram-dotiertes Zinnoxid-haltigen Schicht aus kolumnaren Kristalliten eine homogene Wolfram-dotiertes Zinnoxid-haltige Schicht erhalten wird. Vorzugsweise ist die aus kolumnaren Kristalliten aufgebaute homogene Wolfram-dotierte Zinnoxid-haltige Schicht eine durchgehende Schicht, bei der sich die kolumnaren Kristallite im Wesentlichen über die gesamte Schichtdicke erstrecken.

Vorzugsweise weist die elektrisch leitfähige Beschichtung einen Anteil an kristallinem Wolfram-dotierten Zinnoxid, vorzugsweise kristallinem Wolfram-dotierten Zinn(IV)-Oxid, in einem Bereich von 50 bis 100 Gew.-%, vorzugsweise aus einem Bereich 75 bis 98 Gew.-%, jeweils bezogen auf das Gesamtgewicht der elektrisch leitfähigen Beschichtung, auf.

Weiter bevorzugt weist die elektrisch leitfähige Beschichtung einen Anteil an amorphem Wolfram-dotierten Zinnoxid von weniger als 10 Gew.-%, vorzugsweise weniger als 2 Gew.-%, jeweils bezogen auf das Gesamtgewicht der Beschichtung, weiter vorzugsweise kein amorphes Wolfram-dotiertes Zinnoxid, auf.

Die Erfinder haben festgestellt, dass mit dem vorgenannten Verfahren eine elektrisch leitfähige Beschichtung bereitgestellt werden kann, die einen sehr geringen Anteil an amorphem Wolfram-dotierten Zinnoxid und vorzugsweise kein amorphes Wolfram-dotiertes Zinnoxid aufweist.

Die Erfinder haben weiterhin festgestellt, dass bei einem Anteil an amorphem Wolfram-dotierten Zinnoxid von weniger als 10 Gew.-%, weiter vorzugsweise von weniger als 2 Gew.-%, vorzugsweise bei Abwesenheit von amorphem Wolfram-dotierten Zinnoxid, jeweils bezogen auf das Gesamtgewicht der elektrisch leitfähigen Beschichtung, in der elektrisch leitfähigen Beschichtung die Anzahl von Defekten in der Kristallstruktur der in der Beschichtung enthaltenen Kristallite verringert wird.

Defekte in der Kristallstruktur der Kristallite sind beispielsweise das Auftreten von Leerstellen, d.h. freie Gitterplätze, die im regulären Kristallgitter besetzt sind, oder das Auftreten von Zwischengitteratomen, die auf Plätzen sitzen, die im regulären Kristallgitter unbesetzt sind.

Durch eine geringe Anzahl von Defekten in der Kristallstruktur der in der Beschichtung enthaltenen Kristallite ist der elektrische Widerstand der hergestellten elektrisch leitfähigen Schicht gering.

Weiterhin wird bei einem Anteil an amorphem Wolfram-dotierten Zinnoxid von weniger als 10 Gew.-%, weiter vorzugsweise von weniger als 2 Gew.-%, vorzugsweise bei Abwesenheit von amorphem Wolfram-dotierten Zinnoxid, in der elektrisch leitfähigen Beschichtung das Auftreten von Fremdphasen in der Beschichtung, beispielsweise in Form von Einschlüssen, Ausscheidungen oder Hohlräumen, verringert.

Das Vorhandensein von Fremdphasen in der elektrisch leitfähigen Beschichtung kann beispielsweise bei mechanischer oder thermischer Belastung der Beschichtung zu mechanischen Spannungen innerhalb der Beschichtung führen. Mechanische Spannungen innerhalb der Beschichtung können zu einem teilweisen oder vollständigen Ablösen der Beschichtung oder dem Auftreten von Rissen führen. Diese führen nachteiligerweise zu einer Verschlechterung der elektrischen Leitfähigkeit.

Bei einer weiteren bevorzugten Variante weist die elektrisch leitfähige Beschichtung einen spezifischen Widerstand von weniger als etwa 7,0 × 10⁻³ Ohm x cm, vorzugsweise von weniger als etwa 5,0 x 10⁻³ Ohm x cm, weiter vorzugsweise von weniger als etwa 4,0 x 10⁻³ Ohm x cm, weiter vorzugsweise von weniger als etwa 3,5 x 10⁻³ Ohm x cm, weiter vorzugsweise von etwa 3,0 x 10⁻³ Ohm x cm, auf.

Gemäß einer bevorzugten Variante der Erfindung liegt der spezifische Widerstand der aufgebrachten elektrisch leitfähigen Schicht in einem Bereich von von etwa 7 x 10⁻³ Ohm x cm bis etwa 2,9 x 10⁻³ Ohm x cm, weiter vorzugsweise von etwa 5 x 10⁻³ Ohm x cm bis etwa 3,1 x 10⁻³ Ohm x cm, noch weiter vorzugsweise von etwa 4 x 10⁻³ Ohm x cm bis etwa 3,2 x 10⁻³ Ohm x cm, noch weiter vorzugsweise von etwa 3,8 x 10⁻³ Ohm x cm bis etwa 3,3 x 10⁻³ Ohm x cm.

Gemäß einer bevorzugten Variante der Erfindung liegt der spezifische Widerstand bei einer Schichtdicke von 170 bis 450 nm in einem Bereich von etwa 7 x 10⁻³ Ohm x cm bis etwa 4,2 x 10⁻³ Ohm x cm.

Gemäß einer weiteren bevorzugten Variante der Erfindung liegt der spezifische Widerstand bei einer Schichtdicke von 450 bis 780 nm in einem Bereich von etwa 4,2 x 10⁻³ Ohm x cm bis etwa 3,8 x 10⁻³ Ohm x cm.

Gemäß einer weiteren bevorzugten Variante der Erfindung liegt der spezifische Widerstand bei einer Schichtdicke von 780 bis 1000 nm bei etwa 4,0 x 10⁻³ Ohm x cm bis 3,8 x 10⁻³ Ohm x cm.

Gemäß einer weiteren bevorzugten Variante der Erfindung liegt der spezifische Widerstand bei einer Schichtdicke von 1000 bis 2000 nm in einem Bereich von etwa 3,8 x 10⁻³ Ohm x cm bis etwa 3,1 x 10⁻³ Ohm x cm.

Gemäß einer weiteren bevorzugten Variante der Erfindung liegt der spezifische Widerstand bei einer Schichtdicke von 2000 bis 5000 nm in einem Bereich von etwa 3,1 x 10⁻³ Ohm x cm bis etwa 3,0 x 10⁻³ Ohm x cm.

Bei einer weiteren bevorzugten Ausführungsform ist die elektrisch leitfähige Beschichtung eine durchgehende Schicht. Unter dem Begriff "durchgehende Schicht" wird eine Beschichtung verstanden, die keine Unterbrechungen aufweist.

Weiter bevorzugt ist die kristallines Wolfram-dotiertes Zinnoxid-haltige Schicht, vorzugsweise Wolfram-dotiertes Zinn(IV)-Oxid-haltige Schicht, eine durchgehende Schicht, die keine Bindemittel enthält. Unter dem Begriff "Bindemittel" werden vorzugsweise Stoffe verstanden, die gleich- oder verschiedenartige Stoffe insbesondere stoffschlüssig miteinander verbinden.

Beispielsweise umfasst eine kristalline Wolfram-dotiertes Zinnoxid-haltige Schicht, vorzugsweise kristallines Wolfram-dotiertes Zinn(IV)-Oxid-haltige Schicht, keine Wolfram-dotierten Zinnoxidpartikel, die in einer Bindemittelphase, beispielsweise Lackschicht oder Silikatschicht, eingebettet sind.

Bei einer bevorzugten Variante der elektrisch leitfähigen Beschichtung wird die kristallines Wolfram-dotiertes Zinnoxid-haltige Schicht, vorzugsweise kristallines Wolfram-dotiertes Zinn(IV)-Oxid-haltige Schicht, durch das erfindungsgemäße Verfahren hergestellt.

Erfindungsgemäß ist die elektrisch leitfähige Beschichtung auf einem keramischen Substrat oder einem polymeren organischen Substrat angeordnet.

Bei einer weiteren bevorzugten Ausführungsform ist die elektrisch leitfähige Beschichtung auf einem keramischen Substrat oder einem polymeren organischen Substrat, vorzugsweise durch das vorgenannte Verfahren aufgebracht.

Vorzugsweise ist die elektrisch leitfähige Beschichtung vollflächig auf das Substrat, aufgebracht.

Die Erfinder haben festgestellt, dass sich mit dem vorgenannten Verfahren in einfacher und kostengünstiger Weise auch größere Substrate, wie beispielsweise ein Dachziegel, eine Fassadenplatte oder eine Fassadenwand, gleichmäßig mit einer Wolfram-dotierten Zinnoxidschicht, vorzugsweise Wolfram-dotierten Zinn(IV)-Oxidschicht, beschichten lassen.

Das keramische Substrat ist vorzugsweise ein grobkeramisches Substrat.

Weiter bevorzugt ist ein keramisches Substrat ein Fassadenelement oder ein Ziegel, vorzugsweise ein Dachziegel.

Weiter bevorzugt ist ein Ziegel, ein Dachziegel, ein Mauerziegel, ein Klinker, oder ein Vormauerstein.

Weiter bevorzugt ist ein Fassadenelement, eine Fassadenplatte oder eine Fassadenwand.

Das polymere organische Substratweist einen Schmelzpunkt oder eine Glasübergangstemperatur von mehr als 300°C, vorzugsweise mehr als 350°C, auf. Geeignete Polymere umfassen beispielsweise Polybenzimidazole oder Polyimide.

Geeignete Polymere sind beispielsweise kommerziell von der Fa. DuPont de Nemours (Neu-Isenburg, Deutschland) unter dem Handelsnamen Kapton^{®} erhältlich. Geeignete Polybenzimidazole sind beispielsweise kommerziell erhältlich von der Fa. Performance Products Inc. (Charlotte, USA) unter dem Handelsnahmen Celazole (PBI) oder von der Fa. Quadrant AG (Zürich, Schweiz) unter dem Handelsnamen Duratron^{®} PBI.

Bei dem erfindungsgemäßen Substrat ist zwischen der elektrisch leitfähigen Beschichtung und dem Substrat wenigstens eine Isolatorschicht angeordnet, die vorzugsweise ein dielektrisches Material enthält oder daraus besteht.

Geeignete Materialien für die Schutzschicht sind beispielsweise nichtmetallische anorganische Oxide, Porzellan, Glas, oder Kunststoff.

Vorzugsweise wird bei dem vorgenannten Verfahren zunächst die wenigstens eine Schutzschicht auf dem Substrat aufgebracht und nachfolgend die elektrisch leitfähige Beschichtung auf der wenigstens einen Schutzschicht angeordnet.

Geeignete Verfahren zum Aufbringen der wenigstens einen Schutzschicht sind aus dem Stand der Technik bekannt. Beispielsweise kann die wenigstens eine Schutzschicht durch Gießen, Streichen, Sprühen, Schleudern oder ähnlichen Verfahren auf das Substrat aufgebracht werden, wobei vorzugsweise die wenigstens eine Schutzschicht anschließend getrocknet und/oder gebrannt wird.

Alternativ kann die wenigstens eine Schutzschicht durch Kleben und/oder Laminieren auf dem Substrat angeordnet werden oder sein.

Bei einer weiteren bevorzugten Ausführungsform der Erfindung ist auf der elektrisch leitfähigen Beschichtung in elektrisch leitfähiger Verbindung wenigstens ein Photovoltaikmodul oder Optoelektronikmodul angeordnet oder anordnungsfähig. Vorzugsweise ist das wenigstens eine Photovoltaikmodul oder Optoelektronikmodul mit der elektrisch leitfähigen Beschichtung verbindbar oder verbunden angeordnet. Vorzugsweise ist das wenigstens eine Optoelektronikmodul ein Touch Panel, ein LCD-Display, ein optischer Sensor oder eine Leuchtdiode.

Bei einer bevorzugten Ausführungsform ist das wenigstens eine Photovoltaikmodul eine Solarzelle, vorzugsweise organische Farbstoffzelle. Eine organische Farbstoffzelle, beispielsweise eine Grätzelzelle, zeichnet sich dadurch aus, dass auch bei diffusem Licht Strom effektiv erzeugt wird. Mithin erfordert eine Farbstoffzelle im Unterschied zu einer Silizium-Solarzelle keine direkte Sonneneinstrahlung. Auch bei einem bewölkten Himmel, beispielsweise im Winter, erzeugt eine Farbstoffzelle sehr effektiv Strom.

Bei einer weiteren Ausgestaltung der Erfindung ist auf der elektrisch leitfähigen Beschichtung zunächst wenigstens eine Platin-haltige oder Platin-Schicht angeordnet. Bei noch einer weiteren Ausgestaltung der Erfindung ist auf der elektrisch leitfähigen Beschichtung zunächst wenigstens eine Graphit-haltige oder Graphit-Schicht angeordnet.

Bei der "Graphit" der Graphit-haltigen Schicht oder der Graphitschicht kann es sich im Sinne der vorliegenden Erfindung um einfachen Graphit, Ruß, Fullerene und/oder Kohlenstoffnanoröhrchen (carbon nano tubes (CNT)) handeln. Die Kohlenstoffnanoröhrchen können dabei einzelwandige Kohlenstoffnanoröhrchen, sogenannte single wall CNTs, oder mehrwandige Kohlenstoffnanoröhrchen, sogenannte multi wall CNTs, sein.

Auf der wenigstens einen Platin-haltigen oder Platin-Schicht bzw. Graphit-haltigen oder Graphit-Schicht ist gemäß einer weiteren erfindungsgemäßen Ausführungsform vorzugsweise wenigstens eine Elektrolytschicht angeordnet. Geeignete Materialien für die wenigstens eine Elektrolytschicht sind aus dem Stand der Technik bekannt und umfassen beispielsweise Iodid, Bromid, Hydrochinon oder andere Redox-Systeme, wie beispielsweise Co(II)/Co(III)-Redoxsysteme.

Vorzugsweise ist auf der wenigstens einen Elektrolytschicht wenigstens eine poröse Schicht, die wenigstens einen Metalloxid-Halbleiter und wenigstens einen lichtempfindlichen Farbstoff umfasst, angeordnet. Unter einem "lichtempfindlichen Farbstoff" wird im Sinne der Erfindung ein Farbstoff verstanden, der durch Umgebungslicht in einen angeregten Zustand versetzt wird. Die angeregten

Farbstoffmoleküle übertragen Elektronen an den Metalloxidhalbleiter, vorzugsweise Titanoxid, weiter vorzugsweise TiO₂.

Geeignete Metalloxid-Halbleiter sind aus dem Stand der Technik bekannt und umfassen beispielsweise Oxide der Übergangsmetalle sowie Oxide der Elemente der dritten Hauptgruppe und der vierten, fünften und sechsten Nebengruppe des Periodensystems der Elemente. Bevorzugte Metalloxid-Halbleiter umfassen Oxide von Titan, Zirkon, Hafnium, Strontium, Zink, Indium, Yttrium, Lanthan, Vanadium, Niob, Tantal, Chrom, Molybdän, Wolfram, Zink, Eisen, Nickel oder Silber, Mischoxide oder Oxidgemische dieser Metalle. Gemäß einer bevorzugten Variante der Erfindung wird Titanoxid, vorzugsweise Titandioxid, als Metalloxid-Halbleiter verwendet. Das Titandioxid liegt vorzugsweise in der Kristallstruktur Anatas vor.

Geeignete lichtempfindliche Farbstoffe sind aus dem Stand der Technik bekannt und umfassen beispielsweise Cis-bis(isothiocyanato)bis(2,2'-bipyridyl-4,4'-dicarboxylato Ruthenium(II) (wird auch als "N3" bezeichnet), Di-tetrabutylammonium-cis-bis(isothiocyanato)bis(2,2'-bipyridyl-4,4'-dicarboxylato)Ruthenium(II) (wird auch als "N719" bezeichnet) und/oder Tris(cyanato)-2,2',2"-terpyridyl-4,4',4"-tricarboxylat)Ruthenium(II) (wird auch als "black dye" bezeichnet) oder Mischungen davon.

Des Weiteren sind dem Fachmann verwendbare lichtempfindliche Farbstoffe aus EP 0525 070 B2 oder der EP 0333 641 A1 bekannt.

Vorzugsweise wird oder ist auf der wenigstens einen porösen Schicht, die wenigstens einen Metalloxid-Halbleiter und wenigstens einen lichtempfindlichen Farbstoff umfasst, eine transparente, leitfähige Elektrode angeordnet, wobei die transparente, leitfähige Elektrode vorzugsweise eine transparente, leitfähige Beschichtung und ein transparentes Substrat aufweist, wobei die transparente, leitfähige Beschichtung die wenigstens eine poröse Schicht kontaktiert.

Geeignete transparente, leitfähige Elektroden sind aus dem Stand der Technik bekannt und umfassen beispielsweise Indiumzinn(IV)oxid beschichtetes Glas, Fluor-dotiertes Zinn(IV)-Oxid beschichtetes Glas, Antimon-dotiertes Zinn(IV)-Oxid oder ein Glassubstrat, das mit einer erfindungsgemäßen Wolfram-dotierten Zinnoxidschicht, vorzugsweise Wolfram-dotierten Zinn(IV)-Oxidschicht, beschichtet ist.

Bei einer bevorzugten Ausführungsform der Erfindung werden oder sind die Komponenten des wenigstens einen Photovoltaikmoduls auf der elektrisch leitfähigen Beschichtung angeordnet. Die Komponenten des wenigstens einen Photovoltaikmoduls, vorzugsweise der wenigstens einen Farbstoffzelle, können als fertiges Schichtpaket, das die wenigstens eine Platin-haltige oder Platin-Schicht bzw. Graphit-haltige oder Graphit-Schicht, die wenigstens eine Elektrolytschicht und die wenigstens eine poröse Schicht und optional eine transparente, leitfähige Elektrode umfasst, auf der elektrisch leitfähigen Beschichtung angeordnet werden oder sein. Alternativ können die Komponenten des wenigstens einen Photovoltaikmoduls nacheinander als einzelne Schichten auf der elektrisch leitfähigen Beschichtung angeordnet werden oder sein.

Beispielsweise wird oder ist auf der elektrisch leitfähigen Beschichtung zunächst wenigstens eine Platin-haltige oder Platin-Schicht bzw. Graphit-haltige oder Graphitschicht 4 angeordnet.

Geeignete Verfahren zum Aufbringen der wenigstens einen Platin-haltigen oder Platin-Schicht bzw. Graphit-haltige oder Graphitschicht 4 sind aus dem Stand der Technik bekannt. Die Platin- oder Platin-haltige Schicht kann beispielsweise durch Gasphasenabscheidung oder Flammenpyrolyse aufgebracht werden oder sein. Die Graphit-haltige oder Graphitschicht kann beispielsweise durch Tauch-, Sprüh- und Drehbeschichtung, Siebdruck oder auch durch Gasphasenabscheidung, wie z.B. chemische Dampfabscheidung aufgebracht werden oder sein.

Auf der wenigstens einen Platin-haltigen oder Platin-Schicht bzw. Graphit-haltigen oder Graphit-Schicht wird oder ist vorzugsweise die wenigstens eine Elektrolytschicht angeordnet. Anschließend wird oder ist auf der wenigstens einen Elektrolytschicht die wenigstens eine poröse Schicht, die wenigstens einen Metalloxid-Halbleiter, vorzugsweise Titanoxid, vorzugsweise Titandioxid, und wenigstens einen lichtempfindlichen Farbstoff umfasst, angeordnet.

Verfahren zum Herstellen wenigstens einer Elektrolytschicht und der wenigstens einen porösen Schicht, die wenigstens ein Metalloxid-Halbleiter, vorzugsweise Titanoxid, vorzugsweise Titandioxid, und wenigstens ein lichtempfindlichen Farbstoff umfasst, sind aus dem Stand der Technik bekannt und werden beispielsweise in EP 0333641 A1 beschrieben. Vorzugsweise wird oder ist nachfolgend auf der wenigstens einen porösen Schicht eine transparente, leitfähige Elektrode angeordnet, wobei die transparente, leitfähige Elektrode vorzugsweise eine transparente, leitfähige Beschichtung und ein transparentes Substrat aufweist und die transparente, leitfähige Beschichtung die wenigstens eine poröse Schicht kontaktiert.

Bei einer bevorzugten Ausführungsform werden oder sind die Bestandteile der organischen Farbstoffzelle und die elektrisch leitfähige Beschichtung versiegelt. Eine langzeitstabile Versiegelung kann vorzugsweise durch Aufbringen von Epoxidharzkleber oder Glaslot erfolgen. Die Versiegelung verhindert beispielsweise, dass der Elektrolyt oder der lichtempfindliche Farbstoff aus der organischen Farbstoffzelle austreten. Mithin dient die Versiegelung der gegenüber der Umgebung offenen Bereiche der organischen Farbstoffzelle.

Glaslot ist ein Glas mit besonders niedriger Erweichungstemperatur, vorzugsweise etwa 400 °C, das zum thermischen Verbinden oder Abdichten von Gegenständen verwendet werden kann. Die Hauptbestandteile von Glaslot sind vorzugsweise Bor und Bleioxid. Bei einer weiteren bevorzugten Ausführungsform der vorliegenden Erfindung wirkt die mit dem vorgenannten Verfahren aufgebrachte elektrisch leitfähige Beschichtung als Kathode oder Anode des wenigstens einen Photovoltaikmoduls oder Optoelektronikmoduls.

Nachfolgend wird die Erfindung durch Beispiele und Figuren veranschaulicht, ohne jedoch den Umfang der Erfindung zu begrenzen.

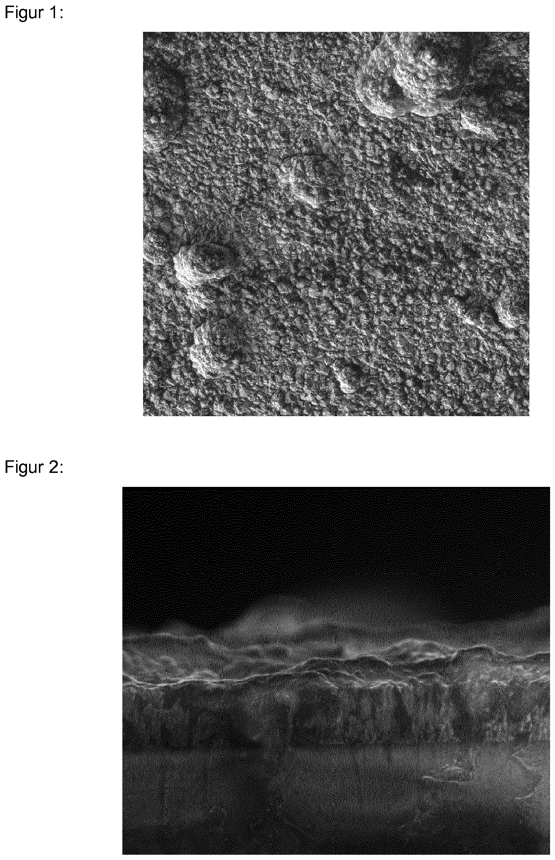

Figur 1 zeigt die Rasterelektronenmikroskop (REM) Aufnahme der in Beispiel 9 erzeugten kristallines Wolfram-dotiertes Zinn(IV)-Oxid-haltigen Schicht mit 5000-facher Vergrößerung.
Figur 2 zeigt die Rasterelektronenmikroskop (REM) Aufnahme eines Querschnitts durch die in Beispiel 9 erzeugten kristallines Wolfram-dotierten Zinn(IV)-Oxid-haltigen Schicht mit 5000-facher Vergrößerung.

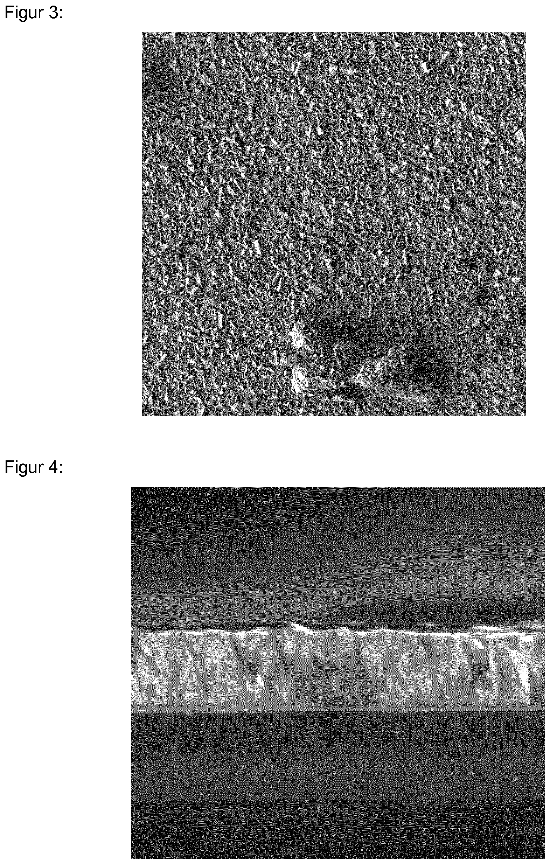

Figur 3 zeigt die Rasterelektronenmikroskop (REM) Aufnahme der in Beispiel 15 erzeugten kristallines Wolfram-dotiertes Zinn(IV)-Oxid-haltigen Schicht mit 5000-facher Vergrößerung.
Figur 4 zeigt die Rasterelektronenmikroskop (REM) Aufnahme eines Querschnitts durch die in Beispiel 15 erzeugte kristallines Wolfram-dotierten Zinn(IV)-Oxid-haltige Schicht mit 5000-facher Vergrößerung.

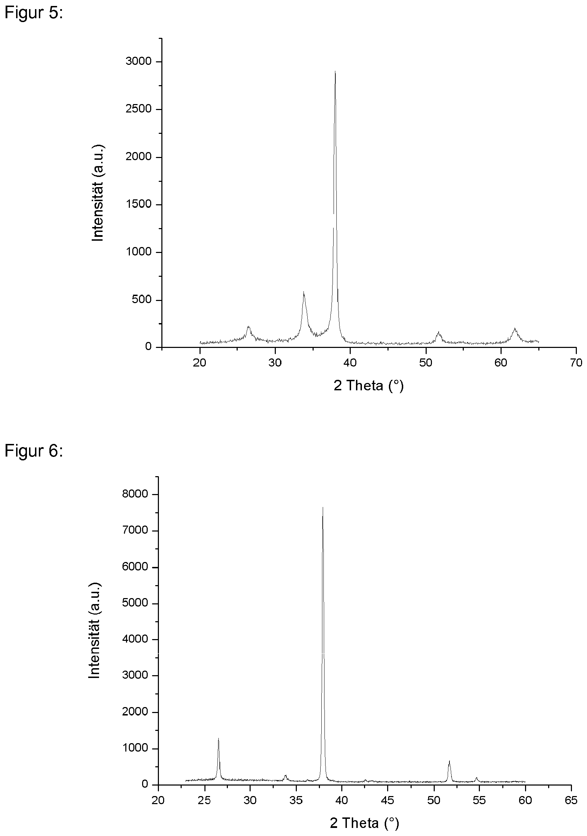

Figur 5 zeigt ein Röntgendiffraktogramm der in Beispiel 9 erzeugten kristallines Wolfram-dotiertes Zinn(IV)-Oxid-haltigen Schicht.
Figur 6 zeigt ein Röntgendiffraktogramm der in Beispiel 15 erzeugten kristallines Wolfram-dotiertes Zinn(IV)-Oxid-haltigen Schicht.

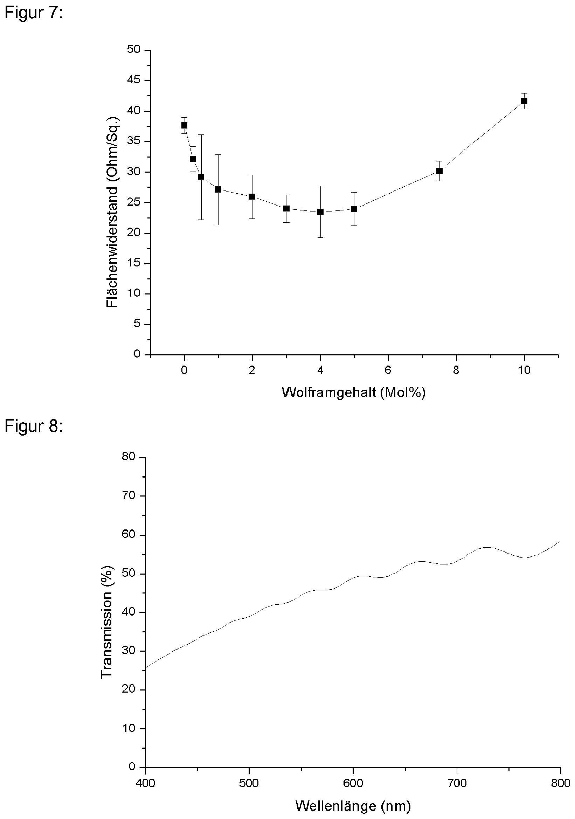

Figur 7 zeigt die Abhängigkeit des Flächenwiderstandes vom Wolframgehalt der in Beispiel 15 erzeugten kristallines Wolfram-dotiertes Zinn(IV)-Oxid-haltigen Schichten.
Figur 8 zeigt UV-VIS Transmissionsspektren, die an der in Beispiel 9 erzeugten kristallines Wolfram-dotiertes Zinn(IV)-Oxid-haltige Schicht in einem Wellenlängenbereich von 400 nm bis 800 nm gemessen wurden.
Figur 9 zeigt einen schematischen Aufbau eines Photovoltaikmoduls, das als organische Farbstoffzelle ausgebildet ist.

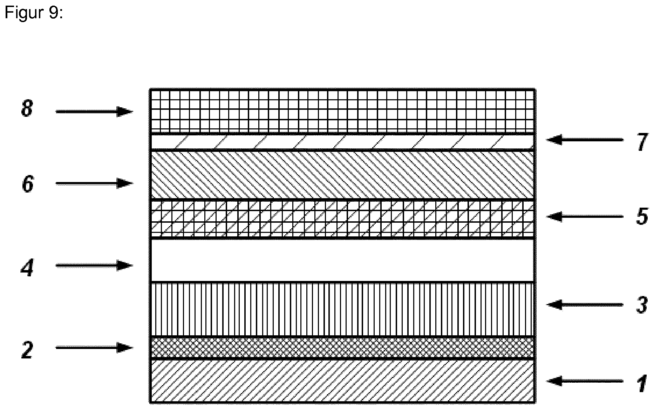

Bei der in Figur 9 dargestellten bevorzugten Ausführungsform der Erfindung ist zwischen der elektrisch leitfähigen Beschichtung 3 und dem Substrat 1 wenigstens eine Schutzschicht 2 angeordnet. Weiterhin ist auf der erfindungsgemäßen elektrisch leitfähigen Beschichtung 3 zunächst wenigstens eine Platin-haltige oder Platin-Schicht 4 oder Graphitschicht 4 angeordnet. Zwischen der Platin-haltigen oder Platin-Schicht 4 oder Graphitschicht 4 und der wenigstens einen porösen Schicht 6 ist die wenigstens eine Elektrolytschicht 5 angeordnet.

Auf der wenigstens einen porösen Schicht 6 ist eine transparente, elektrisch leitfähige Elektrode angeordnet, wobei die transparente, elektrisch leitfähige Elektrode eine transparente, elektrisch leitfähige Beschichtung 7 und ein transparentes Substrat 8 aufweist und die transparente, leitfähige Beschichtung 7 die wenigstens eine poröse Schicht 6 kontaktiert.

In der Figur 9 sind die elektrischen Kontakte der transparenten, elektrisch leitfähigen Beschichtung 7 und der elektrisch leitfähigen Beschichtung 3 sowie die Versiegelung der Randbereiche des Photovoltaikmoduls nicht dargestellt.

### Bezugszeichenliste:

- 1: Substrat
- 2: Schutzschicht
- 3: elektrisch leitfähige Beschichtung
- 4: Platin-haltige oder Platin-Schicht bzw. Graphit-haltige oder Graphitschicht
- 5: Elektrolytschicht
- 6: poröse Schicht, die wenigstens einen lichtempfindlichen Farbstoff enthält
- 7: transparente, elektrisch leitfähige Beschichtung
- 8: transparentes Substrat

### Beispiele

In den Beispielen 1 bis 14 wird jeweils die Herstellung einer Wolfram-dotierten Zinn(IV)-Oxid Schicht mittels Sprühpyrolyse unter den jeweils angegebenen Bedingungen veranschaulicht. In Beispiel 15 erfolgt die Herstellung einer Wolfram-dotierten Zinn(IV)-Oxid Schicht unter Einwirkung eines Ultraschallfeldes. Als Trägergas wurde, wenn angegeben, stets Druckluft verwendet.

### Referenz-Beispiel 1:

Zunächst wurden 100 mL Ethanol vorgelegt und darin 8,77 g (0,025 mol) SnCl₄·5 H₂O unter Rühren gelöst. Es bildete sich eine klare, farblose Lösung. Anschließend wurden 0,307 g (0,77 mmol) WCl₆ unter Rühren zugegeben. Die sodann erhaltene klare, gelbe Lösung ließ man für 24 Stunden bei 20 °C altern. Die erhaltene Vorläuferlösung, die jetzt drei Mol-% Wolfram enthielt (bezogen auf den gesamten Metallionenanteil), wurde im Anschluss bei einem Druck von 0,5 bar, einer Substrattemperatur von 460 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad Electronic SE, D-92240 Hirschau) aufgesprüht.

### Referenz-Beispiel 2:

Zunächst wurden 100 mL Ethanol vorgelegt und darin 8,77 g (0,025 mol) SnCl₄·5 H₂O unter Rühren gelöst. Es bildete sich eine klare, farblose Lösung. Anschließend wurden 0,202 g (0,51 mmol) WCI₆ unter Rühren zugegeben. Die sodann erhaltene klare, gelbe Lösung ließ man für 24 Stunden bei 20 °C altern. Die erhaltene Vorläuferlösung, die jetzt zwei Mol-% Wolfram enthielt (bezogen auf den gesamten Metallionenanteil), wurde im Anschluss bei einem Druck von 0,5 bar, einer Substrattemperatur von 460 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Referenz-Beispiel 3:

Zunächst wurden 100 mL Ethanol vorgelegt und darin 8,77 g (0,025 mol) SnCl₄·5 H₂O unter Rühren gelöst. Es bildete sich eine klare, farblose Lösung. Anschließend wurden 0,100 g (0,25 mmol) WCI₆ unter Rühren zugegeben. Die sodann erhaltene klare, gelbe Lösung ließ man für 24 Stunden bei 20 °C altern. Die erhaltene Vorläuferlösung, die jetzt 1 Mol-% Wolfram enthielt (bezogen auf den gesamten Metallionenanteil), wurde im Anschluss bei einem Druck von 0,5 bar, einer Substrattemperatur von 460 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Referenz-Beispiel 4

Zunächst wurden 100 mL Ethanol vorgelegt und darin 8,77 g (0,025 mol) SnCl₄·5 H₂O unter Rühren gelöst. Es bildet sich eine klare, farblose Lösung. Anschließend wurde 0,521 g (1,32 mmol) WCI₆ unter Rühren zugegeben. Die sodann erhaltene klare, gelbe Lösung ließ man für 24 Stunden bei 20 °C altern. Die erhaltene Vorläuferlösung, die jetzt fünf Mol-% Wolfram enthielt (bezogen auf den gesamten Metallionenanteil), wurde im Anschluss bei einem Druck von 0,5 bar, einer Substrattemperatur von 460 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Referenz-Beispiel 5:

Zunächst wurden 100 mL Ethanol vorgelegt und darin 8,77 g (0,025 mol) SnCl₄·5 H₂O unter Rühren gelöst. Es bildete sich eine klare, farblose Lösung. Anschließend wurden 1,102 g (2,78 mmol) WCI₆ unter Rühren zugegeben. Die sodann erhaltene klare, gelbe Lösung ließ man für 24 Stunden bei 20 °C altern. Die erhaltene Vorläuferlösung, die jetzt zehn Mol-% Wolfram enthielt (bezogen auf den gesamten Metallionenanteil), wurde im Anschluss bei einem Druck von 0,5 bar, einer Substrattemperatur von 460 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Referenz-Beispiel 6:

Die Herstellung der Wolfram-dotierten Zinn(IV)-Oxidschichten erfolgte wie in Beispiel 1 beschrieben, wobei das Aufsprühen jedoch in zwei Intervallen (2 x 25s), zu je 25 Sprühstößen, erfolgte, wobei jeder Sprühstoß von einer Sekunde Dauer war und zwischen den Stößen jeweils eine Sekunde Pause gemacht wurde. Nach jedem Intervall wurde das mittlerweile abgekühlte Natron-Kalk-Glas-Substrat (Größe:4,5 cm x 4,5 cm) erneut auf eine Temperatur von 460 °C aufgeheizt. Durch Verlängerung der Sprühdauer ließen sich gut kontrollierbar dickere Schichten erzeugen.

### Referenz-Beispiel 7:

Die Herstellung der Wolfram-dotierten Zinn(IV)-Oxidschichten erfolgte wie in Beispiel 1 beschrieben, wobei das Aufsprühen jedoch in drei Intervallen (3 x 25s), zu je 25 Sprühstößen, erfolgte, wobei jeder Sprühstoß von einer Sekunde Dauer war und zwischen den Stößen jeweils eine Sekunde Pause gemacht wurde. Nach jedem Intervall wurde das mittlerweile abgekühlte Natron-Kalk-Glas-Substrat (Größe: 4,5 cm x 4,5 cm) erneut auf eine Temperatur von 460 °C aufgeheizt. Durch Verlängerung der Sprühdauer ließen sich gut kontrollierbar dickere Schichten erzeugen.

### Referenz-Beispiel 8:

Die Herstellung der Wolfram-dotierten Zinn(IV)-Oxidschichten erfolgte wie in Beispiel 1 beschrieben, wobei das Aufsprühen jedoch in fünf Intervallen (5 x 25s), zu je 25 Sprühstößen, erfolgte, wobei jeder Sprühstoß von einer Sekunde Dauer war und zwischen den Stößen jeweils eine Sekunde Pause gemacht wurde. Nach jedem Intervall wurde das mittlerweile abgekühlte Natron-Kalk-Glas-Substrat (Größe: 4,5 cm x 4,5 cm) erneut auf eine Temperatur von 460 °C aufgeheizt. Durch Verlängerung der Sprühdauer ließen sich gut kontrollierbar dickere Schichten erzeugen.

### Referenz-Beispiel 9:

Die Herstellung der Wolfram-dotierten Zinn(IV)-Oxidschichten erfolgte wie in Beispiel 1 beschrieben, wobei das Aufsprühen jedoch in sieben Intervallen (7 x 25s), zu je 25 Sprühstößen erfolgte, wobei jeder Sprühstoß von einer Sekunde Dauer war und zwischen den Stößen jeweils eine Sekunde Pause gemacht wurde. Nach jedem Intervall wurde das mittlerweile abgekühlte Natron-Kalk-Glas-Substrat (Größe:4,5 cm x 4,5 cm) erneut auf eine Temperatur von 460 °C aufgeheizt. Durch Verlängerung der Sprühdauer ließen sich gut kontrollierbar dickere Schichten erzeugen.

### Referenz-Beispiel 10:

Zunächst wurden 100 mL Ethanol vorgelegt und darin 8,77 g (0,025 mol) SnCl₄·5 H₂O unter Rühren gelöst. Es bildete sich eine klare, farblose Lösung. Anschließend wurden 0,307 g (0,77 mmol) WCI₆ unter Rühren zugegeben. Die sodann erhaltene klare, gelbe Lösung ließ man für 24 Stunden bei 20 °C altern. Die erhaltene Vorläuferlösung, die jetzt drei Mol-% Wolfram enthielt (bezogen auf den gesamten Metallionenanteil), wurde im Anschluss bei einem Druck von 0,5 bar, einer Substrattemperatur von 400 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Referenz-Beispiel 11:

Zunächst wurden 100 mL Ethanol vorgelegt und darin 8,77 g (0,025 mol) SnCl₄ 5 H₂O unter Rühren gelöst. Es bildete sich eine klare, farblose Lösung. Anschließend wurden 0,307 g (0,77 mmol) WCI₆ unter Rühren zugegeben. Die sodann erhaltene klare, gelbe Lösung ließ man für 24 Stunden bei 20 °C altern. Die erhaltene Vorläuferlösung, die jetzt drei Mol-% Wolfram enthält (bezogen auf den gesamten Metallionenanteil), wurde im Anschluss bei einem Druck von 0,5 bar, einer Substrattemperatur von 500 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Referenz-Beispiel 12:

Zunächst wurden 100 mL Ethanol vorgelegt und darin 8,77 g (0,025 mol) SnCl₄·5 H₂O unter Rühren gelöst. Es bildete sich eine klare, farblose Lösung. Anschließend wurden 0,307 g (0,77 mmol) WCI₆ unter Rühren zugegeben. Die sodann klare, gelbe Lösung ließ man für 24 Stunden bei 20 °C altern. Die erhaltene Vorläuferlösung, die jetzt drei Mol-% Wolfram enthielt (bezogen auf den gesamten Metallionenanteil), wurde im Anschluss bei einem Druck von 0,5 bar, einer Substrattemperatur von 550 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Referenz-Beispiel 13:

Zunächst wurden 100 mL Ethanol vorgelegt und darin 8,77 g (0,025 mol) SnCl₄·5 H₂O unter Rühren gelöst. Es bildete sich eine klare, farblose Lösung. Anschließend wurden 0,307 g (0,77 mmol) WCI₆ unter Rühren zugegeben. Die sodann erhaltene klare, gelbe Lösung ließ man für 24 Stunden altern. Die erhaltene Vorläuferlösung, die jetzt drei Mol-% Wolfram enthielt (bezogen auf den gesamten Metallionenanteil), wurde im Anschluss bei einem Druck von 0,5 bar, einer Substrattemperatur von 600 °C und in 25 Sprühstößen zu je einer Sekunde mit je einer Sekunde Pause auf ein Natron-Kalk-Glas-Substrat (Größe: 4,5 cm x 4,5 cm) über eine Luftdruckdüse (Airbrush-Set, Hersteller: Conrad, siehe Beispiel 1) aufgesprüht.

### Erfindungsgemäßes Beispiel 14:

Zunächst erfolgte die Synthese der Vorläuferlösung analog zu Beispiel 1. Diese wurde im Anschluss bei einem Druck von 0,5 bar, einer Substrattemperatur von 460 °C und in 25 Sprühstößen zu je einer Sekunde mit je einer Sekunde Pause auf ein keramisches Substrat (Dachziegelmaterial der ERLUS AG, Naturrot, Ergoldsbacher E58, Größe: 2cm x 2,5 cm) aufgesprüht.

### Referenz-Beispiel 15:

Zunächst erfolgte die Synthese einer Vorläuferlösung analog zu Beispiel 1. Diese wurde dann mit Hilfe einer Ultraschalldüse bei einer Frequenz von 50,3 kHz und einer Leistung von 6 Watt (Hersteller: Sinaptec, Modell: Inside 200) zerstäubt und im Anschluss bei einem Vorläuferlösung-Volumenstrom von 1,2 mL pro Minute auf ein 460 °C heißes Natron-Kalk-Glas-Substrat (Größe: 2,25 cm x 2,25 cm) über einen Zeitraum von 136 Sekunden aufgedampft. Die Oberflächentemperatur wurde konstant bei 460 °C gehalten.

### Ergebnis

Die so hergestellten Beschichtungen wurden nach der Präparation mittels Röntgenstrukturanalyse (STOE Röntgendiffraktometer in θ-θ-Refiexionsgeometrie), UV/VIS Spektrophotometrie (Varian Carry 100 Bio), Elektronenmikroskopie (JEOL JSM-6700F) und elektrischer Widerstandsmessung (4-Punkt-Methode, Keithley 2400) charakterisiert. Dabei wurde festgestellt, das sowohl Transparenz als auch Flächenwiderstand und spez. Widerstand von den Schichtdicken der Filme abhängen. Das Ergebnis der Charakterisierung der gemäß Beispiel 1 sprühpyrolytisch aufgetragenen Wolfram(VI)dotierten Zinn(IV)-dioxidschicht ist in Tabelle 1 angegeben:

**Tabelle 1: Eigenschaften der gemäß Beispielen 1, 7, 8, 9 und15 sprühpyrolytisch abgeschiedenen Wolfram(VI) dotierten Zinn(IV)-Oxidschichten.**

| Parameter | Beispiel 1 | Beispiel 7 | Beispiel 8 | Beispiel 9 | Beispiel 15 |
|---|---|---|---|---|---|
| Methode | SP | SP | SP | SP | USP |
| Schichtdicke (nm) | 246 | 714 | 1205 | 1717 | 1232 |
| Flächenwiderstand (Ω/Sq.) | 231 | 54 | 33 | 20 | 24 |
| Spez. Widerstand (Ω x cm) | 5,68 × 10⁻³ | 3,86 × 10⁻³ | 3,98 × 10⁻³ | 3,43 × 10⁻³ | 2,96 × 10⁻³ |
| Optische Transparenz (%) | 86 | 74 | 56 | 42 | 65 |

Der Vorteil des sprühpyrolytischen (SP) Verfahrens zur Auftragung transparent leitfähiger Wolfram(VI) dotierter Zinn(IV)-Oxidschichten liegt zum einen darin, dass der Einsatz des teuren Material Indium (das üblicherweise zur Herstellung solcher Schichten eingesetzt wird) vermieden wird.

Aus der CN 101413099 A sind Wolfram(VI) dotierte Zinn(IV)-oxidschichten bekannt. Dort erfolgt die Herstellung transparent leitfähiger Wolfram(VI) dotierter Zinn(IV)-Oxidschichten mittels Puls-Plasma-Abscheidung (PPD):
Gemäß der Lehre der CN 101413099 A wurden zur Herstellung eines Wolfram-Zinnoxid-Targets (Wolframgehalt 2 Gew%) zunächst die entsprechenden Oxide vermischt und gemahlen. Im Anschluss wurde das Stoffgemisch bei 800 °C für 12 Stunden kalziniert und nach dem Abkühlen auf Raumtemperatur für 10 Minuten bei einem Druck von 13 MPa zu einem 3mm dicken Pressling verarbeitet. Dieser wurde im Anschluss in Wasser und Ethanol unter Einfluss von Ultraschall gereinigt. Sodann erfolgte die Abscheidung bei einem Druck von 2,5 Pa in einer Vakuumkammer bei Raumtemperatur auf einem Quarzglassubstrat. Die Abscheidungsdauer lag bei 20 Minuten, und im Anschluss wurde eine Kalzination bei 800 °C in Luft durchgeführt. Die erhaltene Schichtdicke nach der Abscheidung lag bei 109 nm, bei einer optischen Transparenz (sichtbarer Bereich des Lichtes) von 81% und einem spezifischen Widerstand von 7,83 x 10⁻⁴ Ohm x cm.

Im Unterschied zur Lehre der CN 101413099 weist die erfindungsgemäße Beschichtung eine wesentlich größere Schichtdicke auf. Wie Tabelle 2 entnommen werden kann, ist die optische Transparenz der Beschichtung, verglichen mit der Beschichtung gemäß der Lehre der CN 101413099, wesentlich größer.

In Tabelle 2 sind wesentliche Parameter des Verfahrens gemäß der vorliegenden Erfindung und der CN 101413099 A gegenübergestellt. Da die sprühpyrolytisch abgeschiedenen erfindungsgemäßen Beschichtungen dicker sind als die mittels PPD abgeschiedenen, wurden die Parameter der Beschichtung rechnerisch für eine geringere Schichtdicke extrapoliert, um einen direkten Vergleich zu ermöglichen. Die Schichtdicke der sprühpyrolytisch abgeschiedenen Schicht betrug 250 nm (siehe Tabelle 1).

**Tabelle 2: Vergleich der Erfindung mit CN 101413099 A.**

| Parameter | Erfindung (extrapoliert) | CN 101413099 A |
|---|---|---|
| Verfahren | SP | PPD |
| Schichtdicke | 109 nm (heruntergerechnet) | 109 nm |
| Flächenwiderstand | 520 Ω/Sq. | 71 Ω/Sq. |
| Spez. Widerstand | 5,7 x 10⁻³ Ω x cm | 7,83 x 10⁻⁴ Ω x cm |
| Optische Transparenz | 95% | 81% |
| Nachbehandlung | Nein | Ja (3h, 800 °C) |
| Auftragungsdauer | ~12 Sekunden | 20 Minuten |

Es ist zu erkennen, dass die Flächenwiderstände und damit auch die spezifischen Widerstände der mittels PPD hergestellten Filme bei gleicher Schichtdicke niedriger sind als bei den mittels Sprühpyrolyse hergestellten Filmen (Beschichtungen).

Ein großer Vorteil des vorgenannten Verfahrens ist, dass die Beschichtung verfahrenstechnisch schnell und mit sehr niedrigem Aufwand erzeugt werden kann. Die Beschichtung weist dabei eine deutlich größere Schichtdicke auf, die in einem Bereich von 170 bis 5000 nm liegt. Die Auftragsdauer bei dem Verfahren ist mit etwa 12 Sekunden nur ein winziger Bruchteil der gemäß der Lehre der CN 101413099 A erforderlichen Zeitdauer von 20 Minuten.

Zusätzlich muss bei dem vorgenannten Verfahren keine Target-Herstellung erfolgen und keine nachträgliche Kalzination durchgeführt werden. Neben der äußerst geringen Abscheidungsdauer bei dem Verfahren ist insbesondere der apparative Aufwand sehr viel geringer. Im Unterschied zu dem PPD-Verfahren kann auf ein sehr kostenintensives Vakuumverfahren verzichtet werden.

## Patentansprüche

1. Beschichtetes Substrat umfassend wenigstens eine elektrisch leitfähige Beschichtung umfassend kristallines Wolfram-dotiertes Zinnoxid,
**dadurch gekennzeichnet,**
**dass** die wenigstens eine elektrische leitfähige Beschichtung eine Schichtdicke aus einem Bereich von 170 bis 5000 nm aufweist und dass die wenigstens eine elektrisch leitfähige Beschichtung kolumnare Wolfram-dotiertes Zinnoxid-Kristallite umfasst,
wobei zwischen der wenigstens einen elektrisch leitfähigen Beschichtung und dem Substrat eine Isolatorschicht angeordnet ist,
wobei das Substrat ein keramisches Substrat oder ein polymeres organisches Substrat, das einen Schmelzpunkt oder eine Glasübergangstemperatur von mehr als 300°C aufweist, ist.

2. Beschichtetes Substrat nach Anspruch 1,
**dadurch gekennzeichnet,**
**dass** die kolumnaren Kristallite eine säulenartige Struktur aufweisen, wobei die kolumnaren Kristallite im Wesentlichen parallel zueinander ausgerichtet sind.

3. Beschichtetes Substrat nach Anspruch 1 oder 2,
**dadurch gekennzeichnet,**
**dass** der Anteil an kristallinem Wolfram-dotierten Zinnoxid in der wenigstens einen elektrisch-leitfähigen Beschichtung in einem Bereich von 50 bis 100 Gew.-%, vorzugsweise in einem Bereich 75 bis 98 Gew.-%, jeweils bezogen auf das Gesamtgewicht der wenigstens einen elektrisch-leitfähigen Beschichtung, liegt.

4. Beschichtetes Substrat nach einem der Ansprüche 1 bis 3,
**dadurch gekennzeichnet,**
**dass** der Anteil an amorphem Wolfram-dotierten Zinnoxid in der wenigstens einen elektrisch-leitfähigen Beschichtung weniger als 10 Gew.-% beträgt, vorzugsweise dass die wenigstens eine elektrisch-leitfähige Beschichtung kein amorphes Wolfram-dotiertes Zinnoxid aufweist, jeweils bezogen auf das Gesamtgewicht der wenigstens einen elektrisch leitfähigen Beschichtung.

5. Beschichtetes Substrat nach einem der Ansprüche 1 bis 4,
**dadurch gekennzeichnet,**
**dass** das Wolfram-dotierte Zinnoxid Wolfram in einem Anteil von 0,1 bis 20 Molprozent, vorzugsweise 1 bis 5 Molprozent, jeweils bezogen auf die Gesamtstoffmenge an Wolfram und Zinn des Wolfram-dotierten Zinnoxids, enthält.

6. Beschichtetes Substrat nach einem der Ansprüche 1 bis 5,
**dadurch gekennzeichnet,**
**dass** die wenigstens eine elektrisch leitfähige Beschichtung durchgehend ist.

7. Beschichtetes Substrat nach Anspruch 1 bis 6,
**dadurch gekennzeichnet,**
**dass** mit dem mit der wenigstens einen elektrisch leitfähigen Beschichtung versehenen Substrat ein Photovoltaikmodul oder Optoelektronikmodul in elektrisch leitfähiger Verbindung verbindbar oder verbunden ist.

8. Beschichtetes Substrat nach einem der Ansprüche 1 bis 7,
**dadurch gekennzeichnet,**
**dass** die wenigstens eine elektrisch leitfähige Beschichtung als Kathode oder Anode eines Photovoltaikmoduls oder Optoelektronikmoduls wirkt.

9. Beschichtetes Substrat nach einem der Ansprüche 7 oder 8,
**dadurch gekennzeichnet,**
**dass** das Photovoltaikmodul eine Solarzelle, vorzugsweise organische Farbstoffzelle, ist.

10. Beschichtetes Substrat nach einem der Ansprüche 1 bis 9,
**dadurch gekennzeichnet,**
**dass** das keramische Substrat, ein Fassadenelement, ein Ziegel, vorzugsweise Dachziegel oder Mauerziegel, ist.

## Claims

1. Coated substrate comprising at least one electrically conductive coating comprising crystalline tungsten-doped tin oxide,
**characterized**
**in that** the at least one electrically conductive coating has a layer thickness from a range from 170 to 5000 nm and in that the at least one electrically conductive coating comprises columnar tungsten-doped tin oxide crystallites,
wherein an insulator layer is disposed between the at least one electrically conductive coating and the substrate,
wherein the substrate is a ceramic substrate or a polymeric organic substrate having a melting point or a glass transition temperature of more than 300°C.

2. Coated substrate according to Claim 1,
**characterized**
**in that** the columnar crystallites have a column-like structure, wherein the columnar crystallites are oriented essentially parallel to one another.

3. Coated substrate according to Claim 1 or 2,
**characterized**
**in that** the proportion of crystalline tungsten-doped tin oxide in the at least one electrically conductive coating is in a range from 50% to 100% by weight, preferably in a range from 75% to 98% by weight, based in each case on the total weight of the at least one electrically conductive coating.

4. Coated substrate according to any of Claims 1 to 3,
**characterized**
**in that** the proportion of amorphous tungsten-doped tin oxide in the at least one electrically conductive coating is less than 10% by weight, preferably in that the at least one electrically conductive coating does not comprise any amorphous tungsten-doped tin oxide, based in each case on the total weight of the at least one electrically conductive coating.

5. Coated substrate according to any of Claims 1 to 4,
**characterized**
**in that** the tungsten-doped tin oxide contains tungsten in a proportion from 0.1 to 20 mole percent, preferably 1 to 5 mole percent, based in each case on the total molar amount of tungsten and tin in the tungsten-doped tin oxide.

6. Coated substrate according to any of Claims 1 to 5,
**characterized**
**in that** the at least one electrically conductive coating is continuous.

7. Coated substrate according to Claim 1 to 6,
**characterized**
**in that** a photovoltaic module or optoelectronic module is connectable or connected in an electrically conductive connection to the substrate provided with the at least one electrically conductive coating.

8. Coated substrate according to any of Claims 1 to 7,
**characterized**
**in that** the at least one electrically conductive coating acts as cathode or anode of a photovoltaic module or optoelectronic module.

9. Coated substrate according to either of Claims 7 and 8,
**characterized**
**in that** the photovoltaic module is a solar cell, preferably an organic dye-sensitized cell.

10. Coated substrate according to any of Claims 1 to 9,
**characterized**
**in that** the ceramic substrate is a façade element, a tile/brick, preferably roof tile or building brick.

## Revendications

1. Substrat revêtu comprenant au moins un revêtement conducteur de l'électricité comprenant de l'oxyde d'étain cristallin dopé au tungstène,
**caractérisé en ce que**
ledit au moins un revêtement conducteur de l'électricité présente une épaisseur de couche comprise dans une plage de 170 à 5000 nm et **en ce que** ledit au moins un revêtement conducteur de l'électricité comprend des cristallites colonnaires d'oxyde d'étain dopé au tungstène,
dans lequel une couche isolante est disposée entre ledit au moins un revêtement conducteur de l'électricité et le substrat,
dans lequel le substrat est un substrat céramique ou un substrat polymère organique qui présente un point de fusion ou une température de transition vitreuse de plus de 300 °C.

2. Substrat revêtu selon la revendication 1,
**caractérisé en ce que**
les cristallites colonnaires présentent une structure en colonnes, dans lequel lesdites cristallites colonnaires sont orientées sensiblement parallèlement les unes aux autres.

3. Substrat revêtu selon la revendication 1 ou la revendication 2,
**caractérisé en ce que**
la proportion d'oxyde d'étain cristallin dopé au tungstène dans ledit au moins un revêtement conducteur de l'électricité se situe dans une plage de 50 à 100 % en poids, de préférence dans une plage de 75 à 98 % en poids, rapporté dans chaque cas au poids total dudit au moins un revêtement conducteur de l'électricité.

4. Substrat revêtu selon l'une des revendications 1 à 3,
**caractérisé en ce que**
la proportion d'oxyde d'étain amorphe dopé au tungstène dans ledit au moins un revêtement conducteur de l'électricité est inférieure à 10 % en poids, de préférence **en ce que** ledit au moins un revêtement conducteur de l'électricité ne présente pas d'oxyde d'étain amorphe dopé au tungstène, rapporté dans chaque cas au poids total dudit au moins un revêtement conducteur de l'électricité.

5. Substrat revêtu selon l'une des revendications 1 à 4,
**caractérisé en ce que**
l'oxyde d'étain dopé au tungstène contient du tungstène en une proportion de 0,1 à 20 % en moles, de préférence de 1 à 5 % en moles, rapporté dans chaque cas à la quantité totale de tungstène et d'étain dans l'oxyde d'étain dopé au tungstène.

6. Substrat revêtu selon l'une des revendications 1 à 5,
**caractérisé en ce que**
ledit au moins un revêtement conducteur de l'électricité est continu.

7. Substrat revêtu selon l'une des revendications 1 à 6,
**caractérisé en ce que**
le substrat pourvu dudit au moins un revêtement conducteur de l'électricité est un module photovoltaïque ou un module optoélectronique qui peut être raccordé ou qui est raccordé dans une liaison électriquement conductrice.

8. Substrat revêtu selon l'une des revendications 1 à 7,
**caractérisé en ce que**
ledit au moins un revêtement conducteur de l'électricité fait fonction de cathode ou d'anode d'un module photovoltaïque ou d'un module optoélectronique.

9. Substrat revêtu selon l'une des revendications 7 ou 8,
**caractérisé en ce que**
le module photovoltaïque est une cellule solaire, de préférence une cellule à colorant organique.

10. Substrat revêtu selon l'une des revendications 1 à 9,
**caractérisé en ce que**
le substrat céramique est un élément de façade, de préférence une tuile ou une brique.
